# EUROPEAN PATENT SPECIFICATION

(11) **EP 0 376 370 B1**
(45) Date of publication and mention of the grant of the patent: **15.09.1993**
(21) Application number: 89203140.2
(22) Date of filing: 11.12.1989
(51) Int. Cl.: C08F 2/44, H01L 23/29

(54) **Moulding composition, method of encapsulating an electronic component and an encapsulated electronic component**
Giessharzzusammensetzung, Verfahren zum Vergiessen eines elektronischen Bauelementes und vergossenes elektronisches Bauelement
Composition de résine de moulage, procédé pour encapsuler un composant électronique et composant encapsulé

(30) Priority: 15.12.1988 NL 8803066
(43) Date of publication of application: 04.07.1990
(73) Proprietor: Philips Electronics N.V., 5621 BA Eindhoven (NL)
(72) Inventor: Hikmet, Rifat Ata Mustafa, NL-5656 AA Eindhoven (NL); Broer, Dirk Jan, NL-5656 AA Eindhoven (NL)
(74) Representative: Stolk, Steven Adolph

(56) References cited:
- EP-A- 0 057 908
- GB-A- 2 027 042
- US-A- 4 393 020
- US-A- 4 703 338

## Description

The invention relates to a moulding composition comprising liquid-crystalline monomers and fibres.

The invention also relates to a method of encapsulating an electronic component, in particular a semiconductor device, the electronic component being encapsulated using a moulding composition after which the moulding composition is made to cure.

The invention also relates to an electronic component, in particular a semiconductor device, the electronic component being encapsulated in a cured mixture of a moulding composition and fibres.

Such moulding compositions are used, inter alia, in the electronics industry for the manufacture of precision products such as bearings, rotating parts of optical and magnetic systems, housings for optical components, connectors for optical fibres and for encapsulating electronic components. Fibre-reinforced materials in which fibres (for example glass fibres) having a high modulus of elasticity and/or a high tensile strength are embedded in a thermocuring polymer matrix (for example epoxy resin) are being used more and more. Such fibre-reinforced materials exhibit suitable mechanical properties and a low specific mass. Electronic components such as transistors, capacitors and, in particular semiconductor devices (ICs) are encapsulated in polymer materials to protect the components from environmental influences (inter alia moisture) and to enhance their manageability. Thermocuring moulding compositions, such as epoxy resins, are used as encapsulating synthetic resins by virtue of their mechanical and electric properties and their low water absorption. The moulding composition is cured at an increased temperature. During cooling to room temperature mechanical stresses develop in the electronic component and the synthetic resin, which stresses are caused by the fact that the synthetic resin and the electronic component have different coefficients of thermal expansion. These stresses may cause faulty operation and/or failure of the electronic component due to cracking of the synthetic resin and fracture of the electronic component. Other detrimental effects are the displacement of metal tracks (the so-called pattern shift) and breaks in the connection wires or in the welded joints. Due to the formation of cracks moisture can penetrate into the electronic component, which may adversely affect its operation. ICs mostly comprise a silicon chip, which material has a relatively low coefficient of expansion. The synthetic resin used for encapsulating has a relatively high coefficient of expansion, so that in particular with encapsulated ICs stress is an important problem. The difference in coefficient of expansion can be reduced by adding fillers such as silica powder to the casting resin. Rubber or silicones may also be added to reduce the modulus of elasticity. However, as the chip dimensions increase the above solutions are insufficient because the remaining difference in coefficient of expansion still gives rise to too high undesirable stresses.

In United States Patent Specification US 4,683,327 a description is given of a moulding composition which comprises liquid crystalline monomers and a filler such as talc or glass fibres. Such liquid crystalline monomers are oriented relative to each other and can be oriented in a preferred direction, for example, by means of shearing in a flow field. The addition of the said fillers generally leads to a reduction of the coefficient of thermal expansion of the polymerized mixture and to a reduction of polymerization shrinkage.

A disadvantage of the known moulding composition is that for many applications the coefficient of thermal expansion is too high after polymerization. The coefficient of thermal expansion of epoxides and acrylates ranges between 5·10⁻⁵ and 3·10⁻⁴ °C⁻¹. European Patent Specification EP 160829 states that after the addition of 47 % by vol. of glass fibres and silica powder to an epoxide the coefficient of thermal expansion of the cured mixture amounts to 2.05·10⁻⁵ °C⁻¹. As stated in European Patent Application EP 213680 the coefficient of thermal expansion of a polymerized oriented acrylate in the direction of the molecular axis is 2.7·10⁻⁵ °C at 80°C. The reduction of the latter coefficient of expansion requires a considerable quantity of glass fibres and/or silica powder, which causes the orientation of the liquid-crystalline monomers to be disturbed.

It is an object of the invention to provide, inter alia, a moulding composition of the type mentioned in the opening paragraph, having a very low coefficient of expansion.

A further object of the invention is to provide, inter alia, a method of encapsulating an electronic component, in particular a semiconductor device, in which stresses caused by differences in thermal expansion between the electronic component and the cured moulding composition are minimized.

Yet another object of the invention is to provide, inter alia, an encapsulated electronic component of the type mentioned in the opening paragraph, in which no adverse cracks are formed in the synthetic resin and/or the electronic component does not exhibit breaks or other damages.

According to the invention, the object of providing the said moulding composition is achieved by means of a moulding composition as described in the opening paragraph, which is characterized in that the fibres are synthetic resin fibres. Unlike, for example, glass fibres, synthetic resin fibres the longitudinal axes of the polymer molecules of which are oriented in the longitudinal direction of the fibres (fibre direction) exhibit a negative coefficient of thermal expansion. A suitable fibre is, for example, a polyethene fibre having a coefficient of thermal expansion of -1.2·10⁻⁵ °C⁻¹. If such a fibre is brought into contact with liquid crystalline monomers these monomer molecules will be oriented in the direction of the polymer molecules of the fibre, i.e. in the longitudinal direction of the fibre. After the curing of the liquid crystalline monomers a crosslinked system in which the matrix molecules are oriented in the longitudinal direction of the fibres is formed. The polymerized monomer molecules which are located in the vicinity of the synthetic resin fibres have the same low (and negative) coefficient of thermal expansion as the synthetic resin fibres. The content of synthetic resin fibres determines the resulting coefficient of thermal expansion of the polymerized moulding composition. A proportion of 30 % by weight of fibres already suffices to obtain a very low coefficient of thermal expansion. Suitable diameters of the synthetic resin fibres are 5-10 µm, and the length of the fibres may be from approximately 1 mm to many centimeters. When the longitudinal directions of the synthetic resin fibres are randomly distributed, an isotropic cured mass having a low coefficient of thermal expansion is obtained after polymerization of the liquid-crystalline monomer molecules. Suitable liquid-crystalline monomers are, for example, di-(meth)acrylates as shown in the general formula 1 of the formula sheet.

In the formula:
R is a hydrogen atom or a methyl group;
R′ is a hydrogen atom, an alkyl group having 1-4 carbon atoms or a halogen atom;
A is an oxygen atom or the group 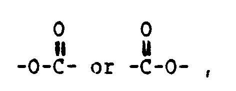 B is the group 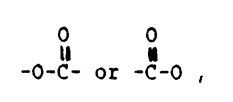
m has a value 1-15;
n is 0 or 1.
An exponent of these di-(meth)acrylates is shown in formula 2 of the formula sheet. Other suitable liquid-crystalline di-(meth)acrylates are, stated, for example, in European Patent Application EP 261712 wherein the method of preparation is also described. Other suitable liquid-crystalline monomers are epoxides which are represented by formula 3 of the formula sheet. In said formula, X is a group which is represented by one of the formulae 4 up to and including 8 of the formula sheet, wherein p has the value 0-20, and M is a mesogenic group, a few examples of which are represented by formulae 9 up to and including 12 of the formula sheet. Other suitable liquid-crystalline monomers are vinyl ethers and thiolene systems which are represented by the formulae 13, 14a and 14b, respectively, of the formula sheet. In these formulae X and X′ have the above meaning of X and M and M′ have the above meaning of M. The value of p is 0-20. To the polymerize the thiolene systems the monomers of formulae 14a and 14b are admixed in equimolar quantities.

According to the invention, a preferred embodiment of the moulding composition is characterized in that the synthetic resin fibres are aromatic polyamide fibres. Such fibres are also called aramide fibres and are manufactured by Dupont under the tradename Kevlar and by Akzo under the tradename Twaron. The coefficient of thermal expansion of Kevlar 49 is much lower than that of polyethene, namely -0.2·10⁻⁵ °C⁻¹.

A suitable embodiment of the moulding composition according to the invention is characterized in that a photoinitiator is added to the composition. (Meth)acrylates and thiolene systems can be polymerized by means of a radical initiator which is sensitive to UV light such as, for example, Darocur 1173 (Merck; see formula 16 of the formula sheet) and Irgacure 651 (Ciba-Geigy; see formula 17 of the formula sheet). The liquid-crystalline monomers are mixed with 1 to 2 % by weight of such a photoinitiator. Cationic initiators, for example Degacure KI 85 (Degussa; see formula 18 of the formula sheet) are used to cure epoxides and vinyl ethers. If desired, the (meth)acrylates and thiolene systems can be cured by using a thermal initiator such as benzoyl peroxide.

According to the invention, the object of providing a method of the type mentioned in the opening paragraph in which stresses caused by differences in thermal expansion between the electronic component and the cured moulding composition are minimized is achieved by a method which is further characterized in that a moulding composition is used which comprises liquid-crystalline monomers and synthetic resin fibres, the liquid-crystalline monomers being polymerized during curing. The method according to the invention can be advantageously used, in particular, when the electronic component is a semiconductor device. The semiconductor device mostly consists of a silicon chip having a coefficient of thermal expansion of 0.5·10⁻⁵ °C⁻¹. The use of a moulding composition according to the invention enables a coefficient of thermal expansion of the cured casting resin of -1.10⁻⁵ °C⁻¹ to be attained. If the moulding composition is cured at an increased temperature, for example 150°C, the thermal stresses will be very small upon cooling to room temperature.

A suitable embodiment of the method according to the invention is characterized in that the moulding composition is polymerized by exposure to UV light. In this case, curing can be carried out at a relatively low temperature at which the monomers have liquidcrystalline properties, for example 80°C. Consequently, the temperature range over which cooling has to take place is smaller so that the thermal stresses occurring are smaller too.

According to the invention, the object of providing an encapsulated electronic component, in particular a semiconductor device, of the type mentioned in the opening paragraph, in which no adverse cracks are formed in the synthetic resin and/or breaks and other damages in the electronic component, is attained by an encapsulated electronic component which is further characterized in that the moulding composition is formed from polymerized liquid-crystalline monomers and fibres which are synthetic resin fibres, the polymerized monomers being oriented in the longitudinal directions of the fibres. As has been stated in the opening paragraph, such a mixture of synthetic resin fibres and polymerized liquid-crystalline monomers has a very low coefficient of thermal expansion which is close to that of many semiconductor materials such as silicon. The thermal stresses occurring due to changes in temperature will be very small, so that cracking and/or breaking are strongly suppressed.

A preferred embodiment of the encapsulated electronic component is characterized in that the synthetic resin fibres are aromatic polyamide fibres. When the quantity of such fibres in synthetic resin amounts to 30 % by weight a coefficient of thermal expansion of -1.10⁻⁵ °C⁻¹ is attained in the temperature range between 80 and 180°C.

Another embodiment of the encapsulated electronic component is characterized in that the cured moulding composition is enveloped by a layer of a second cured moulding composition. This layer is a conventional moulding composition layer and is composed of, for example, an epoxy which is filled with glass powder or quartz powder. The first moulding composition layer is composed of a moulding composition according to the invention and has favourable mechanical properties. Since conventional moulding compositions are cheaper than those according to the invention, the use of a second layer of a conventional moulding composition leads to a cost reduction while the circumferential dimensions of the encapsulated electronic component remain unchanged.

The invention will be explained in greater detail by means of exemplary embodiments and with reference to the accompanying drawings, in which
Fig. 1 shows the relative thermal expansion ε as a function of the temperature T, and
Fig. 2 is a diagrammatic sectional view of an encapsulated semiconductor device.

### Example 1.

Di-acrylate monomers of formula 2 of the formula sheet are mixed with 2 % by weight of Darocur (Merck). Polyethene fibres (Dyneema, marketed by DSM) having a diameter of 10 µm and an average length of 5 cm are added to this mixture. The polyethene fibres are disposed such that they are parallel to each other. The assembly is heated to 80°C at which temperature the said monomers exhibit liquid-crystalline properties. Subsequently, the assembly is exposed to UV light of 360 nm which causes the monomers to polymerize. Examinations using a polarization microscope have shown that the polymerized monomers are oriented in a direction parallel to the direction of the polyethene fibres. The synthetic resin fibres have an orienting effect on the liquid-crystalline monomers.

### Example 2.

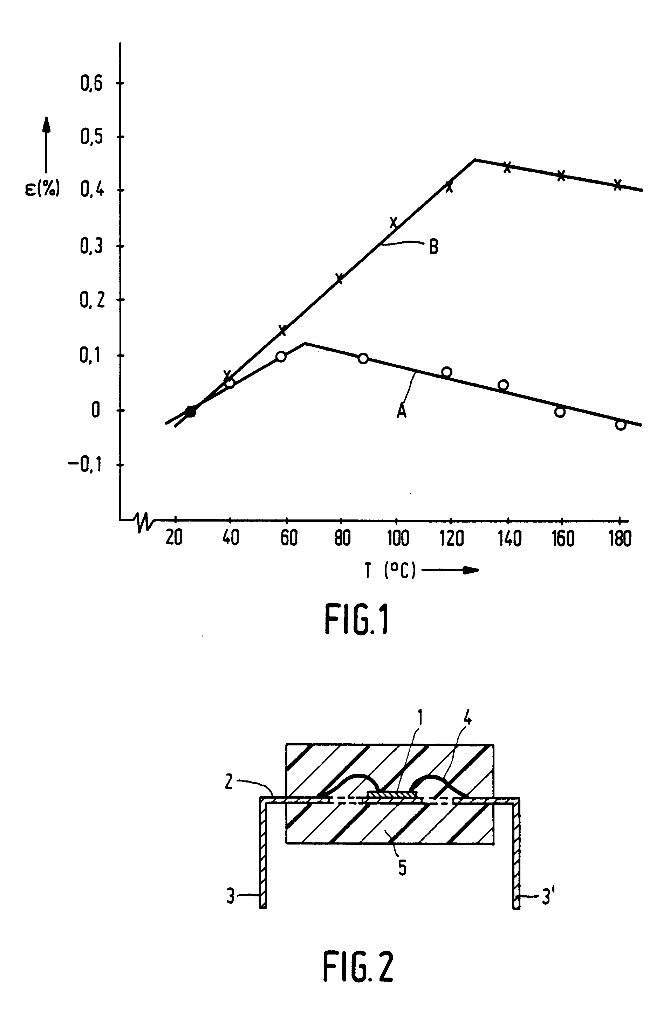

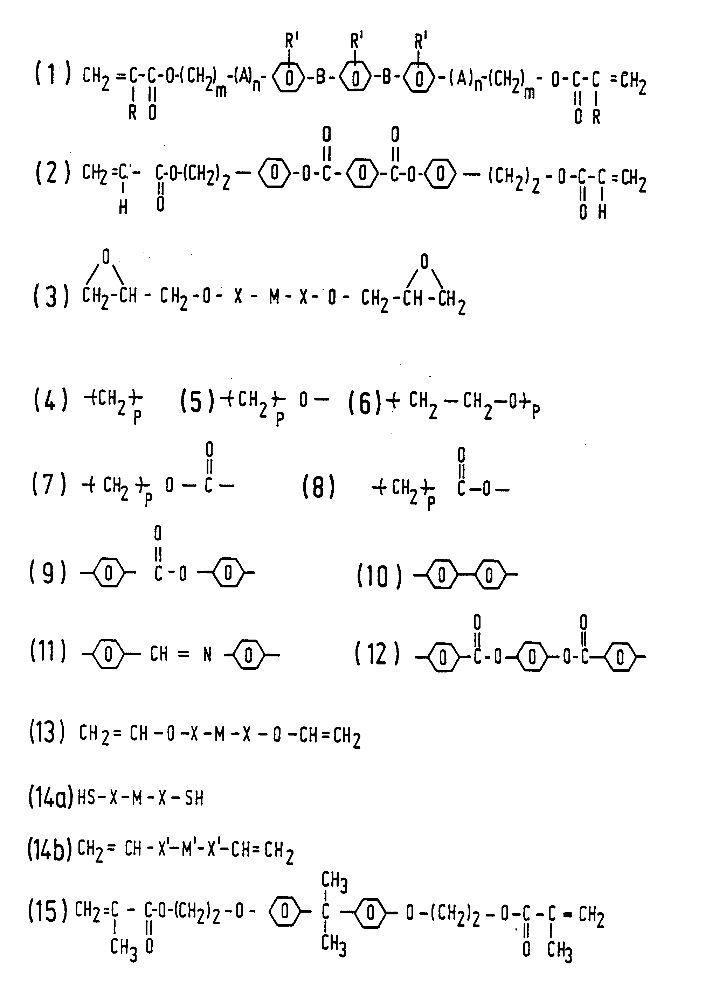

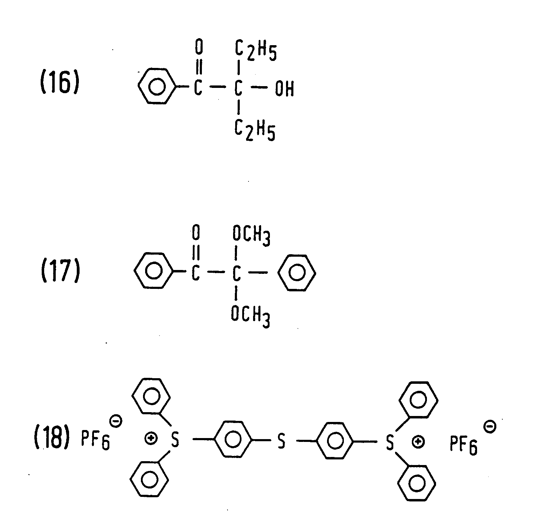

Aromatic polyamide fibres (Kevlar 49, Dupont) having a diameter of 6 µm and a length of approximately 1 mm (chopped fibres) are mixed with di-acrylate monomers of formula 2 of the formula sheet. The content of these fibres is 30 % by weight. 1 % by weight of a photoinitiator (Irgacure, Ciba Geigy) is added to this mixture. After polymerisation of the monomers using UV light of 360 nm, the coefficient of thermal expansion of the mixture is determined in the temperature range from 20° to 180°C (Perkin Elmer TMA). The result is shown in Fig. 1, curve A. The relative expansion ε is plotted on a percentage basis on the vertical axis and the temperature T in °C is plotted on the horizontal axis. Up to a temperature of approximately 60°C the mixture exhibits a positive coefficient of thermal expansion of +3·10⁻⁵ °C⁻¹. Between 60° and 180°C the mixture exhibits a negative coefficient of thermal expansion of -1·10⁻⁵ °C⁻¹.

### Example 3.

By way of comparative example, example 2 is repeated using a similar non-liquid crystalline monomer, namely Diacryl 101 (Akzo), which is again mixed with the same quantity of Kevlar fibres. This monomer is shown in formula 15 of the formula sheet. The measuring results are shown in Fig. 1, curve B. In the temperature range from 20° to 130°C the coefficient of thermal expansion is approximately +5·10⁻⁵ °C⁻¹. Using such non-liquid crystalline monomers no low coefficient of thermal expansion is attained.

### Example 4.

Fig. 2 is a diagrammatic sectional view of an encapsulated semiconductor device. The semiconductor device comprises a silicon chip 1 which is secured to a so-called lead frame 2. This lead frame is made of a metal alloy such as Kovar (Fe-Ni alloy) or bronze. The lead frame also comprises a number of connection pins 3 and 3′. The chip is electrically connected to the lead frame by means of metal wires 4. The chip and the lead frame are encapsulated in the cured moulding composition 5 according to the invention.

## Claims

1. A moulding composition comprising liquid crystalline monomers and fibres, characterized in that the fibres are synthetic resin fibres having a negative coefficient of thermal expansion.

2. A moulding composition as claimed in Claim 1, characterized in that the synthetic resin fibres are aromatic polyamide fibres.

3. A moulding composition as claimed in Claim 1 or 2, characterized in that a photo initiator is added to the composition.

4. A method of encapsulating an electronic component, in particular a semiconductor device, in which the electronic component is encapsulated using a moulding composition after which the moulding composition is made to cure, characterized in that a moulding composition is used which comprises liquid-crystalline monomers and synthetic resin fibres having a negative coefficient of thermal expansion, the liquid-crystalline monomers being polymerized during curing.

5. A method as claimed in Claim 4, characterized in that the moulding composition is polymerized by exposure to UV light.

6. An encapsulated electronic component, in particular a semiconductor device, which is encapsulated in a cured mixture of a moulding composition and fibres, characterized in that the cured moulding composition is formed from polymerized liquid-crystalline monomers and the fibres are synthetic resin fibres having a negative coefficient of thermal expansion, the polymerized monomers being oriented in the longitudinal directions of the fibres.

7. An encapsulated electronic component as claimed in Claim 6, characterized in that the synthetic resin fibres are aromatic polyamide fibres.

8. An encapsulated electronic component as claimed in Claim 6 or 7, characterized in that the moulding composition is enveloped by a layer of a second cured casting resin.

## Patentansprüche

1. Gießharzzusammensetzung mit flüssigkristallinen Monomeren und Fasern, dadurch gekennzeichnet, daß die Fasern Kunststoffasern sind mit einem negativen thermischen Ausdehnungskoeffizienten.

2. Gießharzzusammensetzung nach Anspruch 1, dadurch gekennzeichnet, daß die Kunststoffasern aromatische Polyamidfasern sind.

3. Gießharzzusammensetzung nach Anspruch 1 oder 2, dadurch gekennzeichnet, daß der Zusammensetzung ein Photoinitiator zugesetzt wird.

4. Verfahren zum Einkapseln eines elektronischen Bauelementes, insbesondere einer Halbleiteranodnung, wobei das elektronische Bauelement unter Verwendung einer Gießharzzusammensetzung vergossen wird, wonach die Gießharzzusammensetzung zum Aushärten gebracht wird, dadurch gekennzeichnet, daß ein Gießharz verwendet wird, das flüssigkristalline Monomere und Kunststoffasern mit einem negativen thermischen Ausdehnungskoeffizienten aufweist, wobei die flüssigkristallinen Monomere beim Aushärten polymerisiert werden.

5. Verfahren nach Anspruch 4, dadurch gekennzeichnet, daß das Gießharz durch Belichtung mit UV-Licht polymerisiert wird.

6. Eingekapseltes elektronisches Bauelement, insbesondere eine Halbleiteranordnung, die in einem ausgehärteten Gemisch aus einer Gießharzzusammensetzung und Fasern eingekapselt ist, dadurch gekennzeichnet, daß das Gießharz aus polymerisierten flüssigkristallinen Monomeren gebildet ist und die Fasern Kunststoffasern mit einem negativen thermischen Ausdehnungskoeffizienten sind, wobei die polymerisierten Monomere in der Längsrichtung der Fasern ausgerichtet sind.

7. Eingekapseltes elektronisches Bauelement nach Anspruch 6, dadurch gekennzeichnet, daß die Kunststoffasern aromatische Polyamidfasern sind.

8. Eingekapseltes elektronisches Bauelement nach Anspruch 6 oder 7, dadurch gekennzeichnet, daß das die Gießharzzusammensetzung von einer Schicht einer zweiten ausgehärteten Gießharzzusammensetzung umgeben ist.

## Revendications

1. Composition de résine de moulage comportant des monomères cristallins liquides et des fibres, caractérisée en ce que les fibres sont des fibres en résine synthétique présentant un coefficient d'expansion thermique négatif.

2. Composition de résine de moulage selon la revendication 1, caractérisée en ce que les fibres en résine synthétique sont des fibres de polyamide aromatiques.

3. Composition de résine de moulage selon la revendication 1 ou 2, caractérisée en ce qu'un photo-initiateur est ajouté à la composition.

4. Procédé d'encapsulage d'un composant électronique, particulièrement d'un dispositif semiconducteur, dans lequel le composant électronique est encapsulé en utilisant une composition de résine de moulage après quoi la composition de résine de moulage est durcie, caractérisé en ce que l'on utilise une composition de résine de moulage comportant des monomères cristallins liquides et des fibres en résine synthétique qui présentent un coefficient d'expansion thermique négatif, les monomères cristallins liquides étant polymérisés lors du durcissage.

5. Procédé selon la revendication 4, caractérisé en ce que la composition de résine de moulage est polymérisée en l'exposant à la lumière ultra-violette.

6. Composant électronique encapsulé, particulièrement un dispositif semiconducteur, qui est encapsulé dans un mélange durci constitué d'une composition de résine de moulage et de fibres, caractérisé en ce que la composition de moulage durcie est formée à partir de monomères cristallins liquides polymérisés et que les fibres sont des fibres en résine synthétique présentant un coefficient d'expansion thermique négatif, les monomères polymérisés étant orientés dans les directions longitudinales des fibres.

7. Composant électronique encapsulé selon la revendication 6, caractérisé en ce que les fibres en résine synthétique sont des fibres de polyamide aromatiques.

8. Composant électronique encapsulé selon la revendication 6 ou 7, caractérisé en ce que la composition de résine de moulage est enveloppée par une couche d'une deuxième composition de résine de moulage durcie.
